# EUROPÄISCHE PATENTSCHRIFT

(11) **EP 3 331 840 B1**
(45) Veröffentlichungstag und Bekanntmachung des Hinweises auf die Patenterteilung: **31.07.2019**
(21) Anmeldenummer: 16748123.3
(22) Anmeldetag: 08.08.2016
(51) Int. Cl.: C04B 35/626, C04B 35/462, C04B 35/495

(54) **HERSTELLUNG BLEIFREIER PIEZOKERAMIKEN IN WÄSSRIGER UMGEBUNG**
PRODUCTION OF LEAD-FREE PIEZOCERAMICS IN AQUEOUS SURROUNDINGS
PRODUCTION DE CÉRAMIQUES PIÉZOÉLECTRIQUES SANS PLOMB DANS UN ENVIRONNEMENT AQUEUX

(30) Priorität: 07.08.2015 DE 102015215124; 18.12.2015 DE 102015226082
(43) Veröffentlichungstag der Anmeldung: 13.06.2018
(73) Patentinhaber: CeramTec GmbH, 73207 Plochingen (DE)
(72) Erfinder: SCHREINER, Hans-Jürgen, 91217 Hersbruck (DE); EINHELLINGER-MÜLLER, Tanja, 91207 Lauf (DE); ASSMANN, Friederike, 90607 Rückersdorf (DE)
(74) Vertreter: Fehrenbacher, Eckhard Anton
(86) Internationale Anmeldenummer: PCT/EP2016/068877
(87) Internationale Veröffentlichungsnummer: WO 2017/025505

(56) Entgegenhaltungen:
- WO-A1-02/06184
- WO-A1-2005/069396
- CN-A- 1 978 563
- DE-A1- 19 928 918
- DE-C1- 19 740 262
- GB-A- 1 157 383
- US-A1- 2011 128 665
- EWAIS E M M ET AL: "Gelation of water-based PZT slurries in the presence of ammonium polyacrylate using agarose", JOURNAL OF THE EUROPEAN CERAMIC SOCIETY, ELSEVIER SCIENCE PUBLISHERS, BARKING, ESSEX, GB, Bd. 30, Nr. 16, 1. Dezember 2010 (2010-12-01), Seiten 3425-3434, XP027286099, ISSN: 0955-2219 [gefunden am 2010-09-14]

## Beschreibung

Die vorliegende Erfindung betrifft ein Verfahren zur Herstellung von Keramiken mit piezoelektrischen Eigenschaften in überwiegend wässrigen Suspensionsmitteln.

Im Stand der Technik ist ein Verfahren zum Herstellen piezoelektrischer Keramiken bekannt, bei dem organische Suspensionsmittel verwendet werden. Wässrige Dispersionen sind bei der Herstellung piezoelektrischer Keramiken, wie beispielsweise Bismuth-Natrium-Titanat- (BNT) oder Bismuth-Natrium-Titanat-Barium-Titanat- (BNT-BT) Keramiken, an sich ebenfalls bekannt.

Ewais et al., JEurCeramSoc 20 (2010) 3425-3434 beschäftigen sich mit PZT-Keramiken, d.h. einer bleihaltigen Keramik, deren Ausgangsmaterialien nicht wasserlöslich sind. Dabei wird ein Gel für die Bildung eines Schlickers und zur anschließenden Formung eines Grünlings verwendet. DE19740262 C1 beschreibt perowskitische Keramiken. WO2005/069396 betrifft bleihaltige Keramiken. CN1978563 beschreibt Beschichtungen für Silizium-Stähle.

US 2011/0128665 zeigt eine bleifreie piezoelektrische Keramik, Mischen und Mahlen findet dabei in organischen Lösungsmitteln statt. GB1.157.383 zeigt die Entfernung von Wasser durch erhöhte Temperaturen, d.h. Verdampfen. DE19928918 verwendet ebenfalls Wasser zur Herstellung des Schlickers und der anschließenden Grünlingherstellung, wobei die keramischen Bestandteile sich nicht in Wasser lösen. WO02/06184 A1 zeigt eine bleifreie Keramik, deren zu kalzinierende Ausgangsmaterialien pulverförmig gemischt und gemahlen werden.

Der Nachteil des aus dem Stand der Technik bekannten Verfahrens mit wässrigen Dispersionen ist, dass bei Aufbereitung dieser wässrigen Dispersionen lösliche Bestandteile wie z. B. Alkalien herausgelöst werden können und beim Trocknen segregieren. Dadurch ergibt sich das Problem, dass die gelösten Stoffe in der Keramik inhomogen verteilt werden und die Keramik daher schlechte piezoelektrische Werte aufweist.

Die Aufgabe der vorliegenden Erfindung war, ein Verfahren zu entwickeln, welches die genannten Nachteile nicht aufweist. Die Aufgabe wird durch das erfindungsgemäße Verfahren zur Herstellung von Keramiken mit piezoelektrischen Eigenschaften gelöst, bei dem überwiegend wässrigen Suspensionsmittel verwendet werden. Die hergestellte Keramik mit piezoelektrischen Eigenschaften ist vorzugsweise bleifrei, besonders bevorzugt ist die hergestellte Keramik mit piezoelektrischen Eigenschaften eine Bismut-Natrium-Titanat- (BNT), Bismut-Natrium-Titanat-Barium-Titanat- (BNT-BT), Kalium Natrium Niobat- (KNN) oder Bismut-Natrium-Titanat-Kalium Natrium Niobat- (BNT-KNN) Keramik oder Mischungen daraus.

Die vorliegende Erfindung betrifft ein Verfahren gemäß Anspruch 1 zur Herstellung eines bleifreien Kalzinats für die Herstellung einer bleifreien Keramik mit piezoelektrischen Eigenschaften und ein Verfahren gemäß Anspruch 6 zur Herstellung dieser bleifreien Keramik.

Erfindungsgemäß umfasst das Verfahren zur Herstellung von Keramiken mit piezoelektrischen Eigenschaften das Mischen der Rohstoffe, das Mahlen, die Pressgranulatherstellung sowie weitere Schritte wie das Einfrieren der isotropen Verteilung und eine nachfolgende Temperaturbehandlung.

Ein erfindungsgemäßes Verfahren zur Herstellung eines piezoelektrischen Elements umfasst die Schritte:
a) Mischen der Rohstoffe
b) Mahlen der Rohstoffe
c) Granulation der gemahlenen Rohstoffmischung, z.B. Sprühgefriergranulation
d) Kalzination
e) Schlickerherstellung umfassend das Kalzinat
f) Granulation des Schlickers
g) Presslingherstellung
h) Entbindern und Sintern
i) Metallisieren und Polarisieren

Die Verfahrensschritte Mischen der Rohstoffe und Mahlen werden in überwiegend wässrigen Suspensionsmitteln (Anteil von Wasser am Suspensionsmittel > 80%, bevorzugt > 90%) durchgeführt und eine Segregation der löslichen Bestandteile von den unlöslichen Bestandteilen, was zu inhomogenen Materialien führt, wird durch die Prozessführung verhindert.

Erfindungsgemäß umfasst die so hergestellte Suspension zur Herstellung bleifreier Piezokeramiken 40 - 60 % Keramik, bevorzugt ausgewählt aus Bismut-Natrium-Titanat- (BNT), Bismut-Natrium-Titanat-Barium-Titanat- (BNT-BT), Kalium Natrium Niobat- (KNN) oder Bismut-Natrium-Titanat-Kalium Natrium Niobat- (BNT-KNN) Keramik oder Mischungen daraus, 40 - 60 % Wasser und < 20% , bevorzugt < 5% (organische) Additive.

Die Segregation der löslichen Bestandteile von den unlöslichen Bestandteilen wird insbesondere durch ein Fixieren der in der wässrigen Suspension vorhandenen isotropen Verteilung und anschließendes Entfernen des Suspensionsmediums, ohne dass eine Entmischung ("Segregation") stattfindet, verhindert.

Das Fixieren der isotropen Verteilung kann z. B. durch ein Einfrieren der Suspension erfolgen. Das Einfrieren findet vorzugsweise in einem Gefriermedium (flüssig, fest oder gasförmig) statt, dessen Temperatur unterhalb der Schmelztemperatur der Suspension liegt. Die Temperatur des Gefriermediums ist bevorzugt weit unterhalb der Schmelztemperatur der Suspension, insbesondere > 10 K unterhalb der Schmelztemperatur der Suspension und ermöglicht ein Schockgefrieren der Suspension.

Das Gefriermedium ist ausgewählt aus der Gruppe, bestehend aus flüssiger oder gasförmiger Stickstoff, flüssige oder gasförmige Luft, flüssiger oder gasförmiger Sauerstoff, andere flüssige oder gasförmige organische oder anorganische Medien, bevorzugt flüssiger Stickstoff.

Das Fixieren der isotropen Verteilung durch eine Phasenänderung kann auch durch ein Einfrieren der Suspension mittels physikalischer Methoden, wie Druckveränderungen, feste Medien oder ähnlichen Methoden erfolgen. Das Fixieren kann auch mittels eines Gelationsprozesses o. ä., z. B. durch eine pH-Wert-Änderung (Zeta-Potential), erfolgen. Andererseits ist es auch möglich dass die Fixierung mittels Flockung, z. B. durch eine pH-Wert-Änderung (Zeta-Potential), der Dispersion stattfindet. Auch die Zugabe von einem oder mehreren Additiven ist möglich, um die Fixierung zu erreichen.

Die Entfernung des Suspensionsmittels wird erfindungsgemäß unter Ausschluss von Kapillarkräften und ohne dass eine nennenswerte flüssige Phase entsteht durchgeführt, wodurch die eingefrorene Verteilung erhalten bleibt. Die Entfernung des Suspensionsmittels erfolgt bevorzugt durch Sublimation des überwiegend wässrigen Suspensionsmittels bis zu einer bestimmten, geringen Restfeuchte (< 5%, bevorzugt < 3%) unter geeigneten Druck (< 1bar, bevorzugt < 100 mbar)/ Temperaturverhältnissen erfolgt.

In einer bevorzugten Ausführungsform der erfindungsgemäßen Lehre erfolgt das Einfrieren mittels Eindüsen in ein Gefriermedium, bevorzugt flüssiger Stickstoff, wodurch gleichzeitig ein Protogranulat entsteht. Dieses Protogranulat wird durch Gefriertrocknen zu einem weiterverarbeitungsfähigen Granulat.

Die Entfernung des Suspensionsmittels kann aber auch mittels eines chemischen Prozesses erfolgen, z. B. durch Zersetzung.

Die Überführung der fixierten Verteilung in das gewünschte piezoelektrische keramische Material wird mittels eines Reaktionsprozesses erreicht. Dieser Reaktionsprozess ist vorzugsweise eine Temperaturbehandlung (Kalzination / Mixed-Oxide-Verfahren) der fixierten Verteilung, wodurch ein Kalzinat gebildet wird.

Aus dem so gebildeteren Kalzinat kann ein pressfähiges Pulver hergestellt werden. Dazu wird zunächst ein Schlicker hergestellt Erfindungsgemäß umfasst die so hergestellte Suspension zur Herstellung bleifreier Piezokeramiken 40 - 60 % Keramik, bevorzugt ausgewählt aus Bismut-Natrium-Titanat- (BNT), Bismut-Natrium-Titanat-Barium-Titanat- (BNT-BT), Kalium Natrium Niobat- (KNN) oder Bismut-Natrium-Titanat-Kalium Natrium Niobat- (BNT-KNN) Keramik oder Mischungen daraus, 40 - 60 % Wasser und < 20% , bevorzugt < 5% (organische) Additive.

Aus dem Schlicker wird durch Sprühtrocknung oder andere Granulationsverfahren ein Pulver hergestellt. Ein solches Granulationsverfahren zur Herstellung eines pressfähigen Pulvers aus dem Kalzinat ist vorzugsweise die Sprühgefriergranulation oder die Sprühtrocknung.

Das erfindungsgemäße Verfahren wird im Folgenden am Beispiel 1 der Herstellung einer Bismut-Natrium-Titanat-Barium-Titanat-Keramik (BNT-BT) erläutert, ohne dass es die Erfindung einschränken soll.

### Beispiel 1:

Das Verfahren wird anhand der folgenden Verfahrensschritte durchgeführt:

### 1) Herstellung der Bi₂O₃-Na₂CO₃-TiO₂-Suspension

Es wurden Bi₂O₃, Na₂CO₃, TiO₂, Wasser und Mahlkugeln in einen Behälter eingewogen. Diese Suspension wurde anschließend homogenisiert bzw. deagglomeriert.

### 2) Sprühgefriergranulation der Bi₂O₃-Na₂CO₃-TiO₂-Suspension

Die keramischen Suspension wurde in mit flüssigem Stickstoff befüllte Schalen gesprüht und dadurch schockgefroren. Die Schlickerzufuhr erfolgte mittels Schlauchverbindung über den Vorratsbehälter. Die Produktschalen wurden zu Beginn jedes Sprühvorgangs mit flüssigem Stickstoff befüllt. Aufgrund der Verdampfung des flüssigen Stickstoffs wurde der Füllstand zwischen den Sprüheinheiten regelmäßig kontrolliert und gegebenenfalls Stickstoff nachgefüllt. Dies diente dazu, eine kontinuierliche Bedeckung der gefrorenen Tröpfchen mit flüssigem Stickstoff sicherzustellen und damit ein Wiederaufschmelzen des Schlickers zu verhindern. Nach dem Sprühvorgang wurden die Produktschalen mit den gefrorenen Schlickertröpfchen und dem flüssigem Stickstoff in eine Gefriertrocknungsanlage gegeben. Sobald der flüssige Stickstoff bis auf kleine Reste vollständig verdampft war, wurde der Gefriertrocknungsprozess gestartet, d.h. der Druck in der Gefriertrocknungsanlage gesenkt. Für die Haupttrocknung der Granulate wurde eine Zeit von ca. 24h festgelegt. Auf einen Nachtrocknungsschritt wurde verzichtet.

### 3) Herstellung der Bi₂O3-Na₂CO₃-TiO₂-BaTiO₃-Pulvermischungen

Für die Bi₂O3-Na₂CO₃-TiO₂-BaTiO₃-Pulvermischungen wurde das Sprühgefriergranulat und BaTiO₃-Pulver zu verschiedenen Anteilen (siehe Tabelle 1) in Behälter eingewogen. Nach Zugabe einiger Mahlkugeln wurden die Behälter auf den Walzenstuhl gelegt und trocken gemischt, um ein homogenes Pulvergemisch zu erzeugen.

**Tabelle 1: Molverhältnisse der Rohstoffe**

| Molverhältnis | |
|---|---|
| BT | BNT |
| 0,055 | 0,945 |
| 0,06 | 0,94 |
| 0,065 | 0,935 |
| 0,07 | 0,93 |
| 0,075 | 0,925 |
| 0,08 | 0,92 |
| 0 | 1 |

### 4) Kalzination

Die Bi₂O3-Na₂CO₃-TiO₂-BaTiO₃-Pulvermischungen wurden auf Schalen verteilt. Die Kalzination der Pulvermischungen zu BNT-BT erfolgte bei 900°C.

### 5) BNT-BT-Schlickerherstellung

Nach der Kalzinierung wurden die BNT-BT-Pulver mittels einer Planetenkugelmühle gemahlen. Nach Abtrennen der Mahlkugeln wurde den Schlickern organische Additive zugegeben. Die Schlicker wurden nochmals auf dem Walzenstuhl homogenisiert.

### 6) Sprühgefriergranulation der BNT-BT-Schlicker

Analog zu Schritt 2)

### 7) Pressen der BNT-BT-Bauteile

Die Herstellung der Presslinge erfolgte mit Hilfe einer uniaxialen Presse bei ca. 200 MPa Pressdruck.

### 8) Entbindern und Sintern

Die Grünteile wurden bei 800°C entbindert. Im Anschluss wurden die Presskörper in Kapseln gelegt und gesintert.

### 9) Metallisieren und Polarisieren

Durch Schleifen der Flächen wurde die Dicke der gesinterten Tabletten auf 1mm eingestellt. Die beidseitige Metallisierung erfolgte mit Silberpaste, welches mittels Siebdruck aufgebracht und bei 700-900°C eingebrannt wurde. Zur Polung wurde ein trapezförmiges Spannungsprofil angelegt, wobei die Maximalspannung zwischen 2 und 5 kV variiert wurde.

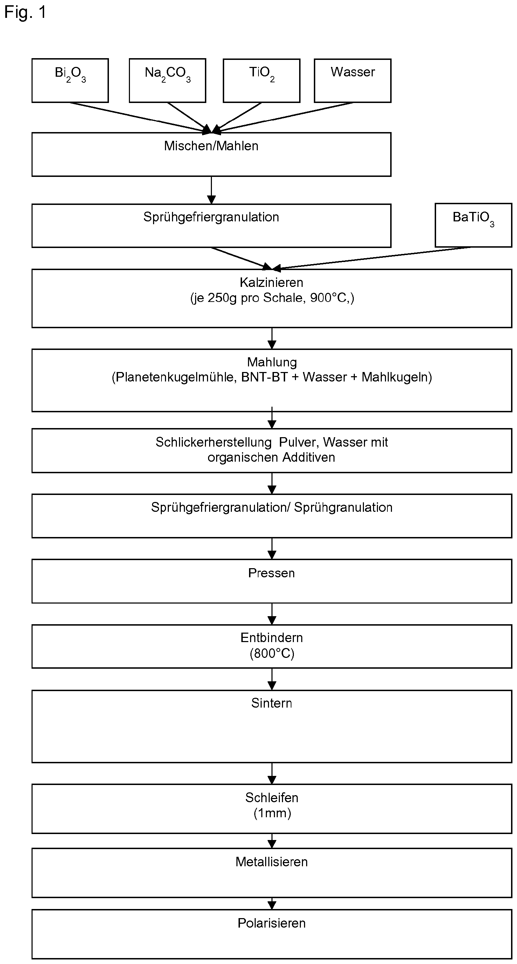

Zum besseren Verständnis ist der Verfahrensablauf des Beispiels 1 als Flussdiagramm in Fig. 1 dargestellt.

Auf diese Weise wurden verschiedene Piezokeramiken hergestellt, deren charakteristische Parameter mittels der in der DIN 50324 1-3 (Stand Dezember 2002) definierten Verfahren ermittelt wurden.

**Tabelle 2: Testergebnisse für erfindungsgemäße Piezokeramiken**

| | BNT-BT6 | BNT |
|---|---|---|
| d₃₃ (pC/N) | 200 | 87 |
| kₚ (%) | 30 | 16 |
| kₜ (%) | 50 | 44 |
| ε^{T}₃₃/ε₀ | 1000 | 460 |
| ρ (g/cm³) | 5,8 | 5,8 |

Erfindungsgemäß handelt es sich somit um ein Verfahren zur Herstellung einer Keramik mit piezoelektrischen Eigenschaften, wobei überwiegend wässrige Suspensionsmittel verwendet werden.

Bevorzugte Ausgestaltungen sind nachfolgend angegeben:
Ausgestaltung 1: Verfahren zur Herstellung einer Keramik mit piezoelektrischen Eigenschaften, wobei die Rohstoffe im ersten Verfahrensschritt in überwiegend wässrigen Suspensionsmitteln gemischt und gemahlen werden, wobei eine Suspension mit isotroper Verteilung entsteht.
Ausgestaltung 2: Verfahren zur Herstellung einer Keramik mit piezoelektrischen Eigenschaften nach Ausgestaltung 1, wobei die isotrope Verteilung der Suspension im nachfolgenden Verfahrensschritt fixiert wird.
Ausgestaltung 3: Verfahren zur Herstellung einer Keramik mit piezoelektrischen Eigenschaften nach Ausgestaltung 2, wobei die Fixierung der isotropen Verteilung durch ein Einfrieren der Suspension erfolgt.
Ausgestaltung 4: Verfahren zur Herstellung einer Keramik mit piezoelektrischen Eigenschaften nach Ausgestaltung 3, wobei das Einfrieren in einem flüssigen, festen oder gasförmigen Gefriermedium stattfindet.
Ausgestaltung 5: Verfahren zur Herstellung einer Keramik mit piezoelektrischen Eigenschaften nach Ausgestaltung 4, wobei die Temperatur des Gefriermediums unterhalb der Schmelztemperatur der Suspension liegt, vorzugsweise weit unterhalb der Schmelztemperatur.
Ausgestaltung 6: Verfahren zur Herstellung einer Keramik mit piezoelektrischen Eigenschaften nach Ausgestaltung 5, wobei die Suspension schockgefroren wird.
Ausgestaltung 7: Verfahren zur Herstellung einer Keramik mit piezoelektrischen Eigenschaften nach einer der Ausgestaltungen 4 bis 6, wobei das Gefriermedium ausgewählt ist aus der Gruppe, bestehend aus flüssigem oder gasförmigem Stickstoff, flüssiger oder gasförmiger Luft, flüssigem oder gasförmigem Sauerstoff oder anderen flüssigen oder gasförmigen organischen oder anorganischen Medien Ausgestaltung 8: Verfahren zur Herstellung einer Keramik mit piezoelektrischen Eigenschaften nach einer der Ausgestaltungen 3 bis 6, wobei Einfrieren mittels Eindüsen in ein Gefriermedium erfolgt, wodurch ein Protogranulat entsteht.
Ausgestaltung 9: Verfahren zur Herstellung einer Keramik mit piezoelektrischen Eigenschaften nach Ausgestaltung 2, wobei die Fixierung der isotropen Verteilung mittels physikalischer Methoden, wie Druckveränderungen, feste Medien o.ä.; mittels Gelationsprozessen; mittels Flockung der Dispersion oder mittels Zugabe von Additiven erfolgt.
Ausgestaltung 10: Verfahren zur Herstellung einer Keramik mit piezoelektrischen Eigenschaften nach einer der vorstehenden Ausgestaltungen, wobei das Suspensionsmittel unter Ausschluss von Kapillarkräften und ohne, dass eine nennenswerte flüssige Phase entsteht, entfernt wird.
Ausgestaltung 11: Verfahren zur Herstellung einer Keramik mit piezoelektrischen Eigenschaften nach Ausgestaltung 10, wobei das Entfernen des Suspensionsmittels durch Sublimation erfolgt.
Ausgestaltung 12: Verfahren zur Herstellung einer Keramik mit piezoelektrischen Eigenschaften nach einer der Ausgestaltungen 2 bis 11, wobei die fixierte isotrope Verteilung mittels eines Reaktionsprozesses in ein piezoelektrisches Material überführt wird.
Ausgestaltung 13: Verfahren zur Herstellung einer Keramik mit piezoelektrischen Eigenschaften nach Ausgestaltung 12, wobei der Reaktionsprozess eine Temperaturbehandlung (Kalzination) ist, wodurch ein Kalzinat erhalten wird.
Ausgestaltung 14: Verfahren zur Herstellung einer Keramik mit piezoelektrischen Eigenschaften nach Ausgestaltung 13, wobei aus dem Kalzinat ein pressfähiges Pulver mittels eines Granulationsverfahrens hergestellt wird.
Ausgestaltung 15: Verfahren zur Herstellung einer Keramik mit piezoelektrischen Eigenschaften nach Ausgestaltung 14, wobei das Granulationsverfahren die Sprühtrocknung oder die Sprühgefriergranulation ist.

Suspension zur Herstellung einer Keramik mit piezoelektrischen Eigenschaften, wobei die Suspension 40 - 60 % Keramik, bevorzugt ausgewählt aus Bismut-Natrium-Titanat- (BNT), Bismut-Natrium-Titanat-Barium-Titanat- (BNT-BT), Kalium Natrium Niobat- (KNN) oder Bismut-Natrium-Titanat-Kalium Natrium Niobat- (BNT-KNN) Keramik oder Mischungen daraus, 40 - 60 % Wasser und < 20% , bevorzugt < 5% (organische) Additive enthält.

## Patentansprüche

1. Verfahren zur Herstellung eines bleifreien Kalzinats für die Herstellung einer bleifreien Keramik mit piezoelektrischen Eigenschaften mit folgenden Verfahrensschritten:
A) Mischen und Mahlen der Rohstoffe in einem ersten Verfahrensschritt in einem wässrigen Suspensionsmitteln, dessen Anteil an Wasser > 80% beträgt, um eine Suspension mit isotroper Verteilung zu erhalten,
B) Fixieren der isotrope Verteilung der Suspension durch Einfrieren der Suspension,
C) Entfernen des Suspensionsmittels durch Sublimation
D) Überführung der fixierten Verteilung in ein piezoelektrisches keramisches Material durch Kalzination und/oder Mixed-Oxide-Verfahren zum Kalzinat
E) Entnahme des Kalzinats.

2. Verfahren nach Anspruch 1, **dadurch gekennzeichnet, dass** das Fixieren im Verfahrensschritt B durch Einfrieren erfolgt und das Einfrieren in einem flüssigen, festen oder gasförmigen Gefriermedium stattfindet.

3. Verfahren nach Anspruch 2, **dadurch gekennzeichnet, dass** die Temperatur des Gefriermediums unterhalb der Schmelztemperatur der Suspension liegt, vorzugsweise >10 K unterhalb der Schmelztemperatur.

4. Verfahren nach einem der Ansprüche 2 oder 3, **dadurch gekennzeichnet, dass** das Gefriermedium ausgewählt ist aus der Gruppe, bestehend aus flüssigem oder gasförmigem Stickstoff, flüssiger oder gasförmiger Luft, flüssigem oder gasförmigem Sauerstoff oder anderen flüssigen oder gasförmigen organischen oder anorganischen Medien

5. Verfahren nach einem der Ansprüche 2 bis 4, **dadurch gekennzeichnet, dass** Einfrieren mittels Sprühgefriergranulation, d.h. mittels Eindüsen in ein Gefriermedium erfolgt, wodurch ein Protogranulat entsteht.

6. Verfahren zur Herstellung einer bleifreien Kerarmik, wobei sich an das Verfahren zur Herstellung eines bleifreien Kalzinats nach einem der Ansprüche 1 bis 5, folgende Verfahrensschritte anschließen:
F) Erzeugung eines Schlickers aus 40-60% des Kalzinats, 40-60% Wasser und < 20% organische Additive
G) Erzeugung eines pressfähigen Pulvers aus dem Schlicker über Granulationsverfahren
H) Erzeugen eines Presslings
I) Entbinden und Sintern des Presslings
J) Metallisieren und Polarisieren der gesinterten Keramik
K) Entnahme des Produkts.

7. Verfahren nach Anspruch 6 mit piezoelektrischen Eigenschaften nach einem der vorstehenden Ansprüche, **dadurch gekennzeichnet, dass** das Granulationsverfahren des Verfahrensschritts G die Sprühtrocknung oder die Sprühgefriergranulation ist.

## Claims

1. Method for producing a lead-free calcinate for the production of a lead-free ceramic material having piezoelectric properties, comprising the following method steps:
A) mixing and grinding the raw materials in a first method step in an aqueous suspending agent, the water content of which is > 80%, in order to obtain a suspension with isotropic distribution,
B) fixing the isotropic distribution of the suspension by freezing the suspension,
C) removing the suspending agent by means of sublimation,
D) converting the fixed distribution into a piezoelectric ceramic material by means of calcination and/or mixed oxide methods to form the calcinate
E) removing the calcinate.

2. Method according to claim 1, **characterized in that** the fixing in method step B is carried out by freezing and the freezing takes place in a liquid, solid or gaseous freezing medium.

3. Method according to claim 2, **characterized in that** the temperature of the freezing medium is below the melting temperature of the suspension, preferably > 10 K below the melting temperature.

4. Method according to either claim 2 or claim 3, **characterized in that** the freezing medium is selected from the group consisting of liquid or gaseous nitrogen, liquid or gaseous air, liquid or gaseous oxygen or other liquid or gaseous organic or inorganic media.

5. Method according to any of claims 2 to 4, **characterized in that** freezing is carried out by means of spray freeze granulation, i.e. by means of injection into a freezing medium, as a result of which a proto-granular material is produced.

6. Method for producing a lead-free ceramic material, wherein the method for producing a lead-free calcinate according to any of claims 1 to 5 is followed by the following method steps:
F) producing a slip from 40-60% of the calcinate, 40-60% water and < 20% organic additives
G) producing a pressable powder from the slip by means of granulation methods
H) producing a pellet
I) debinding and sintering the pellet
J) metallizing and polarizing the sintered ceramic material
K) removing the product.

7. Method according to claim 6 having piezoelectric properties according to any of the preceding claims, **characterized in that** the granulation method of method step G is spray drying or spray freeze granulation.

## Revendications

1. Procédé de préparation d'un calcinat sans plomb pour la fabrication d'une céramique sans plomb à propriétés piézoélectriques, comprenant les étapes de procédé suivantes :
A) mélange et broyage des matières premières, au cours d'une première étape de procédé, dans un agent de suspension aqueux dont la teneur en eau est supérieure à 80 %, pour obtenir une suspension à distribution isotrope,
B) fixation de la distribution isotrope de la suspension par congélation de la suspension,
C) élimination de l'agent de suspension par sublimation,
D) conversion de la distribution fixe en un matériau céramique piézoélectrique par calcination et/ou un procédé faisant appel à des oxydes mixtes pour le calcinat,
E) élimination du calcinat.

2. Procédé selon la revendication 1, **caractérisé en ce que** la fixation à l'étape de procédé B est réalisée par congélation, et la congélation a lieu dans un milieu de congélation liquide, solide ou gazeux.

3. Procédé selon la revendication 2, **caractérisé en ce que** la température du milieu de congélation est inférieure à la température de fusion de la suspension, de préférence supérieure à 10 K en dessous de la température de fusion.

4. Procédé selon l'une des revendications 2 ou 3, **caractérisé en ce que** le milieu de congélation est choisi dans le groupe constitué par l'azote liquide ou gazeux, l'air liquide ou gazeux, le dioxygène liquide ou gazeux, ou tout autre milieu organique ou inorganique liquide ou gazeux.

5. Procédé selon l'une des revendications 2 à 4, **caractérisé en ce que** la congélation a lieu par granulation par glaçage par pulvérisation, c'est-à-dire par injection dans un milieu de congélation, permettant d'obtenir un protogranulat.

6. Procédé de fabrication d'une céramique sans plomb, dans lequel les étapes de procédé suivantes suivent le procédé de préparation d'un calcinat sans plomb selon l'une des revendications 1 à 5 :
F) production d'un coulis à partir de 40 à 60 % du calcinat, de 40 à 60 % d'eau et de moins de 20 % d'additifs organiques,
G) production, par un procédé de granulation, d'une poudre moulable par compression à partir du coulis,
H) production d'un compact,
I) libération et frittage du compact,
J) métallisation et polarisation de la céramique frittée,
K) retrait du produit.

7. Procédé selon la revendication 6, ayant des propriétés piézoélectriques selon l'une des revendications précédentes, **caractérisé en ce que** le procédé de granulation à l'étape de procédé G est le séchage par pulvérisation ou la granulation par glaçage par pulvérisation.
